## Europäisches Patentamt
## European Patent Office
## Office européen des brevets

(11) Veröffentlichungsnummer: **0 263 244 B1**

# EUROPÄISCHE PATENTSCHRIFT

(45) Veröffentlichungstag der Patentschrift: 02.05.91

(51) Int. Cl.5: **G01R 1/073**, G01R 31/28

(21) Anmeldenummer: 87109884.4

(22) Anmeldetag: 08.07.87

Teilanmeldung 90116283.4 eingereicht am 08/07/87.

(54) **Vorrichtung zum elektronischen Prüfen von Leiterplatten mit Kontaktpunkten in extrem feinem Raster (1/20 bis 1/10 Zoll).**

(30) Priorität: 08.09.86 DE 3630548

(43) Veröffentlichungstag der Anmeldung:
13.04.88 Patentblatt 88/15

(45) Bekanntmachung des Hinweises auf die Patenterteilung:
02.05.91 Patentblatt 91/18

(84) Benannte Vertragsstaaten:
AT BE CH DE ES FR GB IT LI LU NL SE

(56) Entgegenhaltungen:
EP-A- 0 142 119
DE-A- 3 110 056
DE-A- 3 110 056
DE-C- 3 340 180
FR-A- 959 460

IBM TECHNICAL DISCLOSURE BULLETIN,
Band 16, Nr. 10, März 1974, Seiten 3224,3225,
New York, US; A.W. TILL: "Contact Probe"

IDEM

(73) Patentinhaber: **MANIA Elektronik Automatisation Entwicklung und Gerätebau GmbH Technologiepark W-6395 Weilrod 8(DE)**

(72) Erfinder: **Driller, Hubert, Dipl.-Phys. Altkönigstrasse 11 W-6384 Schmitten 3(DE)**
Erfinder: **Mang, Paul Weilbergstrasse 4 W-6384 Schmitten 3(DE)**

(74) Vertreter: **Ruschke, Hans Edvard et al Patentanwälte Dipl.-Ing. Olaf Ruschke Dipl.-Ing. Hans E. Ruschke Dipl.-Ing. Jürgen Rost Dipl.-Chem. Dr. U. Rotter Pienzenauerstrasse 2 W-8000 München 80(DE)**

## Beschreibung

Die Erfindung betrifft eine Vorrichtung zum elektronischen Prüfen von Leiterplatten nach dem Oberbegriff des Anspruches 1 bzw, des unabhängigen Anspruches 2.

Eine derartige Vorrichtung wird im Prinzip von A.W. Till in der Druckschrift IBM Techinal Disclosure Bulletin Vol. 16, No. 10, März 1974, S,3224125 unter dem Titel "Contact Probe" beschrieben, wobei jedoch eine elektronische Ansteuerungs-und Meßvorrichtung, wie sie bie der vorliegenden Erfindung verwendet ist, nicht erwähnt ist.

Wegen des zunehmenden Dranges zur Miniaturisierung aber auch wegen der damit einhergehenden kostengünstigeren Fertigung gehen die Hersteller in aller Welt zunehmend dazu über, elektronische Baugruppen mit Hilfe von Leiterplatten aufzubauen, die Kontaktpunkte oder Kontaktfelder im Rastermaß 1/20 Zoll und bis zu 1/100 Zoll haben. Hierbei bedient man sich weitgehend der sogenannten SMD-Technik (surface mounted devices), bei der die Anschlußdrähte oder -fahnen der einzelnen elektronischen Komponenten nicht mehr mit gegebenenfalls durchkontaktierten Bohrungen mehrlagiger Leiterplatten, sondern mit Anschlußzonen (pads) verbunden werden.

Da sich die Erkenntnis durchgesetzt hat, daß unbestuckte Leiterplatten (bare boards) vor der Bestückung mit elektronischen Bauteilen auf ihre Funktionstüchtigkeit geprüft werden müssen, um sicherzustellen, daß nicht mehr und nicht weniger als alle gewünschten Verbindungen vorhanden sind, ergibt sich für die Hersteller von Leiterplattenprüfgeräten die Notwendigkeit, Geräte anzubieten, mit denen Leiterplatten nahezu in beliebiger Größe und Konfiguration im 1/20 Zoll-Kontaktpunkt-Raster und deutlich darunter problemlos geprßüft werden können.

In der DE-PS 33 40 180 wird eine Kontaktfeldanordnung für rechnergesteuerte Leiterplatten-Prüfgeräte im 1/10 Zoll Kontaktpunkt-Raster beschrieben. Das Kontaktfeld ist hierbei in Kontaktfeldabschnitte unterteilt, die jeweils fur sich über längere Stützstreben gegen eine Grundplatte lösbar abgestützt sind. Der somit geschaffene Raum wird zur Unterbringung der diesen Kontaktfeldabschnitten zugehörigen Elektronikbauteile ausgenützt, die über eine Steckverbindung mit der zweidimensionalen Ansteuerschaltung auf der Grundplatte verbunden sind. Diese "Kontaktfeldmoduln" genannten Bauteile sind untereinander identisch und in Bezug auf die jeweiligen Plätze auf der Grundplatte austauschbar. Durch dieses Konzept wird ein Leiterplattenprüfgerät geschaffen, das trotz eines in der Grundkonzeption sehr groß angelegten Kontaktfeldes (beispielsweise 256 Kontakte jeweils in X- und Y-Richtung) bereits mit wenig Elektronik betreibbar und problemlos nachrüstbar ist.

Dieses Konzept auch bei einem Kontaktpunktraster 1/20 Zoll und darunter zu realisieren ist das grundlegende Bestreben der vorliegenden Erfindung. Es gelingt zwar, mit einem sogenannten "Reduktionsadapter" (DE-PS 33 40 179) die bis zu 64.000 Kontaktpunkte des 1/10-Ausgangsrasters dieser Kontaktfeldanordnung fur alle ca. 64.000 Kontaktpunkte in X- und Y-Richtung des Kontaktfeldes auf ein Raster von 1/20 Zoll zu reduzieren, doch nur um den Preis einer Verringerung der höchstzulässigen Leiterplattenabmessungen um 50 % in beiden Richtungen.

Bei der somit erforderlichen Verwirklichung des Prinzips des Leiterplattenprüfgerätes der DE-PS 33 40 180 im Kontaktpunktraster 1/20 Zoll (gleich 1,27 mm) stößt man zumindest scheinbar auf Grenzen der Miniaturisierung, wie sie im folgenden dargestellt werden sollen. Hierbei ist zu beachten, daß sich diese Grenzen auch von der Kostenseite her auftun. Bei einem Leiterplattenprüfgerät mit einer Kontaktfeldanordnung gemäß der DE-PS 33 40 180 erfolgt die mechanische Kontaktierung der Kontaktpunkte der zu prüfenden Leiterplatte und der Kontaktpunkte des Kontaktfeldrasters des Leiterplattenprüfgerätes durch Prüfnadeln, die jeweils eine in Längsrichtung federnd ausgebildete Kontaktspitze haben. Diese federnden Prüfstifte sind bei dem herkömmlichen Kontaktpunktabstand von 2,54 mm noch relativ einfach und preiswert herstellbar, doch ergeben sich zunehmend Probleme, wenn ein Kontaktpunktabstand von 1,27 mm vorgeschrieben wird, d.h. wenn diesem Prüfstift allenfalls ein Durchmesser von etwa 0,8 mm zugestanden werden kann. Derartig dünne Prüfstifte knicken beispielsweise bei geringsten Querkräften aus und werden damit unbrauchbar. Außerdem lassen sich derartige Prüfstifte mit einer federnden Kontaktspitze wegen der notwendigen mechanischen Komplexität nur zu Gestehungskosten fertigen, die angesichts der maximal benötigten Zahl solcher Prüfstifte zu einem erheblichen Problem werden können. Wo bei gleichen äußeren Abmessungen der Kontaktfeldanordnung beim bisherigen Kontaktpunktraster 1/10 Zoll = 2,54 mm etwa 64.000 Kontaktpunkte maximal vorhanden und mithin entsprechend viele Prüfstifte notwendig waren, werden bei einem Kontaktpunktabstand von 1,27 mm bis zu 256.000 Kontaktpunkte innerhalb der gleichen äußeren Kontaktfeldabmessungen möglich. Es liegt auf der Hand, daß bei der eventuell benötigten sehr hohen Anzahl von Prüfstiften die Kosten für einen einzelnen Prüfstift sehr erheblich und vielleicht kaufentscheidend ins Gewicht fallen können. Es ist daher wesentlich, das Prinzip der Kontaktierung der einzelnen "Kontaktfeldmoduln" gemäß der DE-PS 33 40 180 bei einer Übertragung dieses Prinzips auf extrem feine Kontaktfeldraster so einfach und kostengünstig wie möglich auszugestalten.

Im DE-GM 85 34 841.4 vom 20.2.1986 wird vorgeschlagen, in Länsgrichtung starre konturlose Prüfstifte ohne federnde Kontaktspitzen insbesondere dann zu benutzen, wenn die Leiterplatten bereichsweise Anschlußdichten aufweisen, die größer sind als die mittlere Anschlußdichte im Grundraster des Kontaktfeldes des Leiterplattenprüfgerätes, welches ein Grundraster von 1/10 Zoll hat. Da solche starre konturlose Kontaktstifte sehr einfach und mit einem recht geringen Durchmesser hergestellt werden können, d.h. also daß Kontaktdichten geprüft werden können, die zumindest bereichsweise kleiner sind als das Grundraster des Leiterplattenprüfgerätes, ohne daß sich eine ernsthafte Gefahr von Kurzschlüssen zwischen den einzelnen Prüfstiften ergibt, und da solche konturlose starre Prüfstifte sehr preiswert hergestellt werden können, scheint es sich zunächst anzubieten, derartige starre Prüfstifte auch bei der Leiterplattenprüfung/Kontaktierung im 1/20 Zoll Raster einzusetzen. Allerdings muß hierbei beachtet werden, daß bei dieser bekannten Lösung gemäß DE-GM 85 34 841.4 (Flexadapter) ein sogenanntes "aktives Grundraster" für den Längenausgleich zwischen allen eingesetzten starren Prüfstiften und somit für die zuverlässige Kontaktgabe aller dieser Prüfstifte mit den Prüflingen wie Leiterplatten, Keramik-Verdrahtungsträgern oder flexiblen Leiterplatten zu sorgen hat. Ein solcher Längenausgleich ist notwendig, um ein mögliches Ausbiegen der starren Feststifte und eine variable Dicke der gedruckten Leiterplatten zu kompensieren und um einen guten Kontaktdruck sicherzustellen. Ein derartiges aktives Grundraster entsteht dadurch, daß der federnde Teil der Kontaktstifte in das Grundraster des Leiterplattenprüfgerätes verlegt wird, was in der Form geschieht, daß kurze kleine Prüfstifte in Form von Hülsen vorgesehen werden, von denen das eine Ende eine Kontaktspitze und das andere Ende einen Innenkonus aufweist, der von einer in der Hülse angeordneten Feder abgestützt wird und zur Aufnahme des einen Endes des starren Prüfstiftes dient. In dem aktiven Grundraster gemäß DE-GM 85 34 841 sind also viele kurze "Prüfstifte mit Innenkonus" entsprechend der Anzahl der vorgesehenen Kontaktpunkte in einem geeigneten Gehäuse oberhalb des eigentlichen Grundrasters des Leiterplattenprüfgerätes vorgesehen. Das grundlegende Problem der relativ hohen Herstellungskosten derartiger "Prüfstifte mit Innenkonus" ist damit also nicht beseitigt - ebenso nicht, daß solche hülsenförmige Prüfstifte mit einer darin angeordneten Druckfeder sehr schwierig - wenn überhaupt - auf Durchmesser in der Größenordnung von 0,8 mm reduziert werden können, wenn bei derart dünnen und somit schwachen Federn ein noch hinreichender Kontaktdruck zugelassen werden soll, zumal die Wandstärke de r Hülse aus Gründen der Materialfestigkeit nicht unter 0,2 mm gesenkt werden kann. Es ergäben sich also letztlich auch erhebliche Probleme bei der Realisierung eines derart dicht gepackten "aktiven Grundrasters" für ein Kontaktpunktraster 1/20 Zoll.

In der FR-A- 959460 (Appert) ist der Aufbau eines Kontaktsteckers gezeigt, bei dem ein Kontaktstift in eine konisch gewickelte Kontaktfeder eingesteckt wird, die in einem Sackloch eines Steckerkörpers angeordnet und jeweils an ihrem Anfang und Ende mit Hilfe von Schrauben in dem Sackloch fixiert ist. Derartige Amschlußtechniken sind nur bei wenigen und zudem verhältnismäßig großen Kontaktsteckern wirtschaftlich tragbar.

Es ist daher die der vorliegenden Erfindung zugrundeliegende Aufgabe, die Art der Kontaktierung der Kontakte einer zu prilfenden Leiterplatte mit dem Kontaktpunktraster des LP-Prüfgerätes dahingehend zu verbessern, daß sich auch bei einem extrem feinen Kontaktpunktraster von 1/20 Zoll (1,27 mm) oder deutlich darunter weder von der Kostenseite noch von der Festigkeitsseite her Probleme wie oben dargestellt ergeben.

Diese Aufgabe wird erfindungsgemäß durch die Merkmale des Anspruches 1 gelöst. Indem die Druckfedern selbst zur Aufnahme der starren Prüfstifte vorgesehen und entsprechend ausgestaltet werden, gelingt es trotz der erforderlichen Miniaturisierung, ein funktionierendes und zu erträglichen Kosten herstellbares Kontaktfeldraster vorzusehen.

Eine Herstellung des Federkontaktfeldkörpers aus Keramik oder Kunststoff ist insofern besonders vorteilhaft, als dabei Herstellungstechniken verwendet werden können, die eine besondere Maßhaltigkeit gestatten. Auch wird die Herstellung des Federkontaktfeldkörpers dadurch besonders erleichtert, daß er aus kleineren aneinander anreihbaren oder zusammenfügbaren Abschnitten aufgebaut wird.

Um den pro Druckfeder zur Verfügung stehenden Anteil des gesamten Anpreßdruckes möglichst wirkungsvoll zur Erzeugung eines sicheren Kontaktes zur Wirkung kommen zu lassen, kann es besonders vorteilhaft sein, ein oder beide Enden der Druckfedern so zu wickeln, daß eine stift- oder kegelähnliche Gestalt dort vorgesehen wird.

Weiterhin kann es von Vorteil sein, ein oder beide Enden der Druckfedern so zu wickeln, daß ein Innenkonus zur direkten Aufnahme eines Prüf- oder Kontaktstiftes entsteht. Dadurch haben diese Stifte dann einen sicheren Halt unmittelbar auf der Druckfeder.

Um eine besonders gute Führung der Druckfedern in ihren Bohrungen zu erreichen, können sie in ihren Endbereichen aneinanderliegende Windungen maximalen Durchmessers aufweisen. Zur weiteren Verbesserung der mechanischen Stabilität der Druckfedern können sämtliche aneinanderliegenden Windungen der Druckfedern mechanisch miteinander verbunden werden, was etwa durch galvanische Abscheidung eines Metalles auf den meist aus Federstahl hergestellten Druckfedern geschieht. Dadurch werden dann die aneinanderliegenden Windungen der Druckfeder "zusammenwachsen". Ein Überziehen der Endabschnitte der Druckfedern mit einem speziellen Kontaktwerkstoff - eventuell ebenfalls durch galvarische Abscheidung - kann zur erheblichen Verringerung des Kontaktwiderstandes beitragen.

Insbesondere wenn der die Druckfedern in Bohrungen aufnehmende bzw. fuhrende Federkontaktfeldkörper aus rasterförmig zusammenfügbaren kleineren Segmenten aufgebaut ist, hat es sich als besonders vorteilhaft erwiesen, diese auf ein Tragteil aufzubringen, das als nagelbrettartiger Stecker ausgebildet ist und zur Kraftableitung des aufgebrachten Druckes dient und entsprechend im Leiterplattenprufgerät abgestützt ist.

Wenn dieser Stecker im Verhältnis zu den rasterförmig zusammenfügbaren Segmenten des Federkontaktfeldkörpers relativ groß ist, kann er fur einen guten Zusammenhalt der einzelnen Segmente untereinander sorgen.

Ein Ausfuhrungsbeispiel der vorliegenden Erfindung wird unter Bezugnahme auf die beigefügten Zeichnungen näher beschrieben. Darin zeigt:

Fig. 1 eine Übersicht über den grundsätzlichen Aufbau eines - allerdings nicht vollständig dargestellten - Leiterplattenprüfgerätes, das nach der vorliegenden Erfindung aufgebaut ist;

Fig. 2 in Seiten- bzw. Draufsicht eine sogenannte Treiberplatte mit dem am oberer Ende angeordneten Nagelbrettstecker, der auf Tragschienen abgestützt ist;

Fig. 3 eine ausschnittsweise Teil vergrößerung der erfindungsgemäßen Kontaktierung zwischen der Treiberplatte (der Prüfelektronik) und den starren Prüfstiften; und

Fig. 4a, b, c verschiedene Alternativen der Ausgestaltung der Druckfedern im Federkontaktfeldkörper.

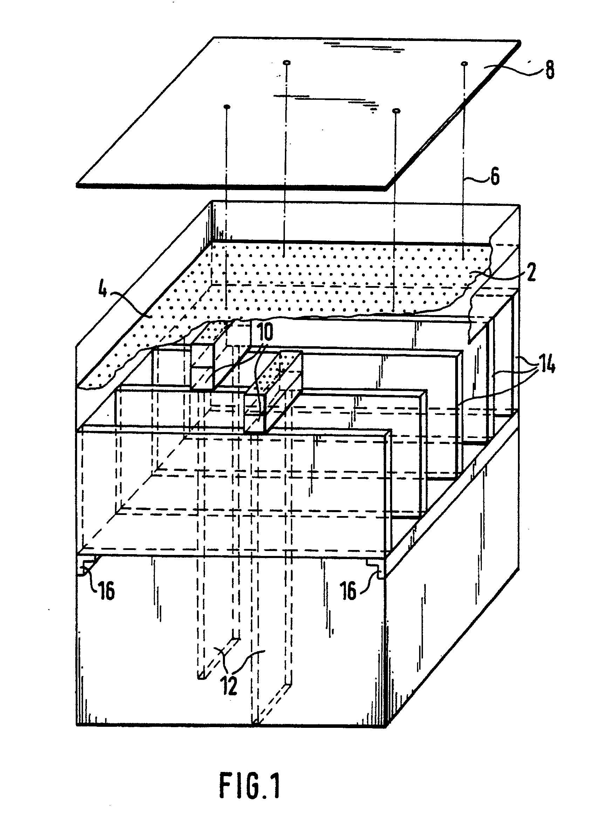

In Fig. 1 ist in prinzipieller Darstellung die Anordnung und Abstützung der einzelnen Bauteile dargestellt, die zusammen das Kontaktfeld 2 mit den einzelnen, beispielsweise bis zu ca. 265.000 Kontaktfeldpunkten 4 ausbilden, die über Prüfstifte 6 mit dem zu prüfenden Verdrahtungsträger/Leiterplatte 8 verbindbar sind. Jeweils 4×32 Kontaktfeldpunkte 4 sind einem nagelbrettartigen Kontaktfeldstecker 10 zugeordnet, der am oberen Ende einer sogenannten Treiberplatte 12 sitzt, die die Elektronikbauteile trägt, die zur elektronischen Prüfung der 4×32 = 128 Kontaktpunkte eines Kontaktfeldsteckers 10 beitragen.

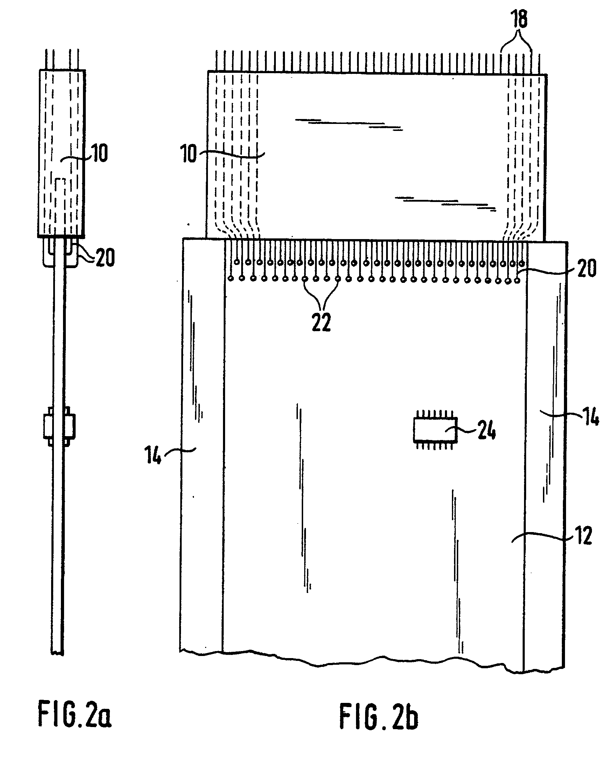

Am unteren Ende dieser Treiberplatte 12 sind nicht dargestellte Kontaktstecker vorgesehen, die jede der bis zu 2.000 Treiberplatten 12 (Kontaktfeldmoduln) mit einer elektronischen Ansteuerungs- und Meßvorrichtung verbinden, die im unteren Teil der Prüfvorrichtung angeordnet (nicht dargestellt) ist und auf die hier nicht näher eingegangen wird. Wie aus Fig. 2 ersichtlich ist, liegt jeder nagelbrettartige Kontaktfeldstecker 10 an seinen beiden stirnseitigen Enden an Tragteilen 14 auf, die von hochkant angeordneten Platten ausgebildet werden, die den sehr erheblichen Kontaktdruck auf das Gestell 16 des Leiterplattenprüfgerätes ableiten: Da beim Prüfen von Leiterplatten 8 zur Erzeugung eines zuverlässigen Kontaktes eine Andruckkraft von ca. 1,23N (125 p) pro Kontakt 4 erzeugt werden muß, ergibt sich bei den genannten maximal 256.000 Kontakten eine Gesamtkraft von $0,31.10^6$ N, was einem Gewicht von ca. 32 t entspricht, das über diese Tragteile 14 abgeleitet werden muß.

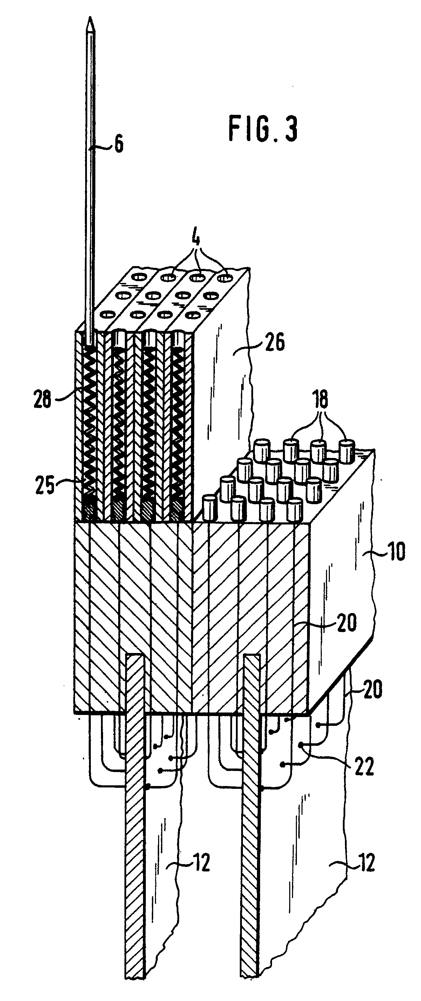

Der aus einem elektrisch nicht leitenden Werkstoff wie Kunststoff oder Keramik bestehende Kontaktfeldstecker 10 weist auf seiner oberen Stirnfläche beispielsweise 4×32 = 128 senkrecht nach oben weisende Kontaktstifte 18 auf, die jeweils einen Durchmesser in der Größenordnung von 0,8 mm haben und beispielsweise 2,5 mm hoch sind. Diese Kontaktstifte 18 des Kontaktfeldsteckers 10 setzen sich im Inneren desselben in Leitungen 20 fort, die jeweils mit einem Anschlußpunkt 22 auf der gedruckten Schaltung der Treiberplatte 12 verbunden sind und somit die elektrische Verbindung mit den elektronischen Komponenten 24 (nur eine ist dargestellt) auf der Treiberplatte 12 herstellt, die Teil der Prüfschaltung des Leiterplattenprüfgerätes sind. Jeder der Kontaktstifte 18 ragt in eine Bohrung 25 eines Federkontaktfeldkörpers 26 hinein, die eine Kontaktfeder 28 aus elektrisch leitendem Werkstoff enthält und diese Bohrung 25 im wesentlichen ausfüllt. In dem gezeichneten bevorzugten Ausführungsbeispiel der Fig. 3 besteht der Federkontaktfeldkörper 26 aus zahlreichen Streifen mit jeweils einer Reihe von Bohrungen darin (entsprechend der Anordnung der Kontaktstifte), doch liegt es auf der Hand, daß es sich nicht um streifenförmige Körper mit nur einer Reihe von Bohrungen 25 handeln muß, sondern es ist ebenso gut möglich, mehrere oder viele Reihen von Bohrungen in einem entsprechend größer gestalteten Federkontaktfeldkörper 26 vorzusehen, da die Größe der Unterteilung dieser Federkontaktfeldkörper an sich nur von der gunstigsten Herstellbarkeit solcher Körper abhängig ist: Zur Zeit werden allerdings wegen der genaueren Herstellbarkeit solche Körper als Streifen mit nur einer Reihe von Bohrungen bevorzugt, wobei diese Streifen in Längsrichtung (Fig. 3) oder auch in Querrichtung (nicht dargestellt) auf den Kontaktfeldsteckern 10 angeordnet sein können, d.h. im letztgenannten Fall erstrecken sie sich gerade über die Breite der Kontaktfeldstecker 10. Die Streifen sind etwa 50 mm hoch und 1,27 mm breit. Die Bohrungen darin haben einen Durchmesser von ca. 0,8 mm und der Abstand von Bohrung zu Bohrung beträgt entsprechend dem Rastermaß der Kontaktpunkte 1,27 mm.

Die Federkontaktfeldkörper 26 werden auf den bzw. die nagelbrettartigen Kontaktfeldstecker 10 aufgesteckt. In jede somit von unten von jeweils einem Kontaktstift 18 abgeschlossene Bohrung 25 wird eine besonders ausgebildete Druckfeder 28 eingesetzt, die diese Bohrung vollständig ausfüllt, d.h., die Windungen der Druckfeder liegen im federnden Teil derselben unmittelbar an den Wandungen der Bohrung an, so daß trotz der beengten Platzverhältnisse Druckfedern mit dem größtmöglichen Durchmesser verwendet werden können.

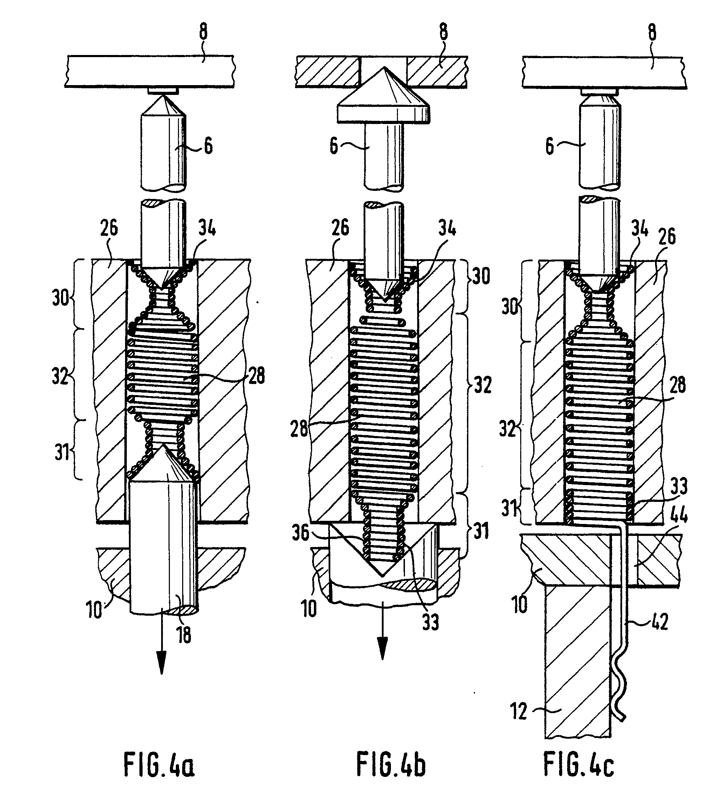

Die stirnseitigen Enden 30, 31 der Druckfedern 28, die in der Fig. 3 nur in prinzipieller Darstellung gezeigt sind, sind in besonderer Weise zur direkten Kontaktierung mit dem Kontaktstift 18 des nagelbrettartigen Kontaktfeldsteckers 10 bzw. dem starren Prüfstift 6 ausgestaltet. Gemäß Fig. 4a ist die Druckfeder 28 an beiden stirnseitigen Enden, d.h. auswärts vom federnden Teil 32, der voneinander beabstandete Windungen aufweist, mit in Längsrichtung aneinanderliegenden Windungen gewickelt, die zur Ausbildung eines Innenkonusses sich in Wickelrichtung der Feder im Durchmesser verjungen und anschließend wieder erweitern. Auf diese Weise wird an beiden Stirnseiten dieser Druckfeder ein Innenkonus 34 zur Aufnahme der Spitzen des Kontaktstiftes 18 bzw. des Prüfstiftes 6 ausgebildet. Vorzugsweise können diese aus einem Federstahl gewickelten Druckfedern 28 durch galvanische Abscheidung mit einem geeigneten Kontaktwerkstoff beschichtet sein, wobei die aneinanderliegenden Windungen an den stirnseitigen Enden "zusammenwachsen" können.

Aus Fig. 4b ist eine alternative Kontaktierungsform ersichtlich. Die Druckfeder ist in ihrem oberen Bereich zum Angriff an dem Prüfstift 6 identisch ausgebildet, d.h., sie weist einen wie zuvor beschrieben gewickelten Innenkonus 34 auf, während das entgegengesetzte Ende mit einem sich stiftartig verjüngenden Ansatz 36 gewickelt ist, dessen einzelne Windungen 33 wiederum aneinanderliegen. Dieser stiftartige Ansatz ragt in eine beispielsweise kegel- oder napfförmige Vertiefung im Kontaktfeldstecker 10 hinein, wobei diese Vertiefung als Alternative zu den zuvor beschriebenen Kontaktstiften 18 anzusehen ist.

In der Fig. 4c ist eine weitere alternative Ausführungsform der Druckfeder gezeigt: Das dem Kontaktfeldstecker bzw. der Treiberplatte zugewandte Ende der Druckfeder 28 ist mit einem sich in Längsrichtung der Druckfeder erstreckenden Kontaktzungenteil 42 versehen, der sich unmittelbar bis zu dem zugehörigen Kontaktpunkt auf der Oberfläche der Treiberplatte 12 erstreckt. Dies bedeutet, daß der Kontaktfeldstecker lediglich mit entsprechend positionierten dünnen Bohrungen 44 versehen sein muß, durch die diese Kontaktzungen 42 beim Aufbau des Kontaktfeldes eingeführt werden. Das dem Prüfstift 6 zugewandte Ende der Druckfeder 28 ist auch in diesem Fall so gewickelt, daß ein Innenkonus 34 aus in Längsrichtung aneinanderliegenden Windungen der Druckfeder gebildet wird.

Es liegt auf der Hand, daß die erfindungsgemäße besondere Art der Kontaktierung der in Längsrichtung starren Prüfstifte 6 über als Druckfedern (Spiralfedern) ausgebildete Kontaktpunkte ebenso gut auch bei Leiterplattenprüfgeräten eingesetzt werden kann, die mit einem fest verdrahteten Kontaktpunktraster versehen sind, also keine Kontaktfeldmoduln aufweisen, die untereinander identisch und in Bezug auf die jeweiligen Plätze auf der Grundplatte austauschbar sind. Dennoch ist die vorliegende Erfindung gerade bei diesem letztgenannten Konzept besonders wertvoll, da es ebenso wie die vorliegende Erfindung wesentlich darauf abstellt, die für die Kontaktierung der zu prüfenden Leiterplatte/Verdrahtungsträger anfallenden Kosten stark zu reduzieren.

BEZUGSZEICHENLISTE

2 Kontaktfeld
4 Kontaktfeldpunkte
6 Prüfstifte
8 Leiterplatte
10 Kontaktfeldstecker (Nagelbrett-)
12 Treiberplatte
14 Tragteile
16 Gestell
18 Kontaktstifte
20 Leitungen
22 Anschlußpunkt
24 elektr. Komponenten
26 Federkontaktfeldkörper
28 Kontaktfeder/Druckfeder
30 stirnseitige Enden der Druckfeder
31 stirnseitige Enden der Druckfeder
32 federnder Teil der Druckfeder
33 Windungen der Druckfeder
34 Innenkonus
36 stiftartiger Ansatz
42 Kontaktzungenteil
44 Bohrungen

## Ansprüche

1. Leiterplattenprüfgerät mit einer Vielzahl von in der Kontaktfeldebene (2) des Gerätes angeordneten Kontaktpunkten (4), die an eine elektronische Ansteuerungs-und Meßvorrichtung angeschlossen sind und über in Längsrichtung starre Prüfstifte (6) mit den Leiterbahn-Kontaktpunkten der zu prüfenden Leiterplatten (8) verbindbar sind, wobei die Kontaktpunkte (4) im Leiterplattenprüfgerät gegen den aufzubringenden Kontaktdruck von elektrisch leitenden Druckfedern (28) abgestützt sind, die in Bohrungen (25) eines Federkontaktfeldkörpers (26) aus elektrisch isolierendem Material angeordnet sind und auf denen die starren Prüfstifte (6) direkt abgestützt sind, dadurch gekennzeichnet, daß die Druckfedern (28) mit ihrem Mittelteil unmittelbar anliegend an den Wandungen der Bohrungen (25) im Federkontaktfeldkörper (26) geführt sind, wobei sie in den Endbereichen (30, 31) in Längsrichtung der Druckfeder aneinanderliegende Windungen (33) maximalen Federwickel durchmessers zur Ausbildung einer stabilen Führung im Federkontaktfeldkörper (26) aufweisen, und daß die Druckfedern (28) an mindestens einem Ende (30, 31) aufgrund einer Verringerung und anschließenden Vergrößerung des Federwickeldurchmessers bei gleichzeitigem Aneinanderliegen der Windungen (33) die Form eines Innenkonusses (34) zur direkten Aufnahme eines Prüfstiftes (6) oder eines Kontaktstiftendes (18) zum Anschluß an die Prüfschaltung des Leiterplattenprüfgerätes aufweisen.

2. Leiterplattenprüfgerät mit einer Vielzahl von in der Kontaktfeldebene (2) des Gerätes angeordneten Kontaktpunkten (4), die an eine elektronische Ansteuerungs-und Meßvorrichtung angeschlossen sind und über in Längsrichtung starre Prüfstifte (6) mit den Leiterbahn-Kontaktpunkten der zu prüfenden Leiterplatten (8) verbindbar sind, wobei die Kontaktpunkte (4) im Leiterplattenprüfgerät gegen den aufzubringenden Kontaktdruck von elektrisch leitenden Druckfedern (28) abgestützt sind, die in Bohrungen (25) eines Federkontaktfeldkörpers (26) aus elektrisch isolierendem Material angeordnet sind und auf denen die starren Prüfstifte (6) direkt abgestützt sind, dadurch gekennzeichnet, daß die Druckfedern (28) mit ihrem Mittelteil unmittelbar anliegend an den Wandungen der Bohrungen (25) im Federkontaktfeldkörper (26) geführt sind, wobei sie in den Endbereichen (30, 31) in Längsrichtung der Druckfeder aneinanderliegende Windungen (33) maximalen Federwickel durchmessers zur Ausbildung einer stabilen Führung im Federkontaktfeldkörper (26) aufweisen, und daß die Druckfedern (28) an mindestens einem Ende (30, 31) aufgrund einer stufenförmigen und/oder kontinuierlichen Verringerung des Federwickeldurchmessers bei gleichzeitigem Aneinanderliegen der Windungen (33) eine stift- oder kegelähnliche Gestalt (36) zur direkten Kontaktierung eines Innenkonusses oder einer sonstigen Kontaktfläche aufweisen.

3. Gerät nach einem der voranstehenden Ansprüche, dadurch gekennzeichnet, daß die aneinanderliegenden Windungen der Druckfedern mechanisch miteinander verbunden sind, etwa durch galvanische Abscheidung eines Metalles.

4. Gerät nach einem der voranstehenden Ansprüche, dadurch gekennzeichnet, daß die Endbereiche (30, 31) der Druckfedern zur Kontaktverbesserung mit einem speziellen Kontaktwerkstoff überzogen sind.

5. Gerät nach einem der voranstehenden Ansprüche, dadurch gekennzeichnet, daß eine als Träger für die zur Ansteuerung erforderlichen elektronischen Bauelemente (24) dienende Treiberplatte (12) an ihrer Stirnseite einen nagelbrettartigen Kontaktfeldstecker (10) trägt, der auf der den Prüfstiften abgewandten Seite des Federkontaktfeldkörpers (26) angeordnet ist und sowohl zur unmittelbaren elektrischen Kontaktierung mit den Druckfedern (28) als auch zur Kraftableitung zu den Tragteilen (14, 16) im Leiterplattenprüfgerät dient.

6. Leiterplattenprüfgerät nach einem der voranstehenden Ansprüche, dadurch gekennzeichnet, daß der Federkontaktfeldkörper (26) aus Keramik oder Kunststoff hergestellt ist.

7. Leiterplattenprüfgerät nach einem der voranstehenden Ansprüche, dadurch gekennzeichnet, daß der Federkontaktfeldkörper (26) aus rasterförmig anreihbaren, zusammenfügbaren Segmenten aufgebaut ist.

8. Gerät nach Anspruch 7, dadurch gekennzeichnet, daß durch Einstecken der Kontaktstifte (18) eines oder mehrerer Kontaktfeldstecker (10) in die Bohrungen (25) eines oder mehrerer Segmente des Federkontaktfeldkörpers (26) ein in sich stabiler Abschnitt des Kontaktfeldes gebildet wird, der als komplette Einheit entnehmbar und austauschbar ist.

9. Gerät nach Anspruch 8, dadurch gekennzeichnet, daß das vom prüfstift (6) abgewandte Ende der Druckfeder mit einer sich in Längsrichtung der Feder, von dieser weg erstreckenden federnden Kontaktzunge (42) versehen ist zum direkten Angriff an Kontaktzonen der die Elektronikbauteile des Kontaktfeldabschnittes tragenden Treiberplatte (12).

10. Leiterplattenprüfgerät nach einem der voranstehenden Ansprüche, dadurch gekennzeichnet, daß Bereiche unterschiedlicher Anschlußdichte in der Kontaktfeldebene ( 2) vorhanden sind, die je nach den Anforderungen der zu prüfenden Leiterplatte (8) untereinander austauschbar sind.

**Claims**

1. Printed circuit board test device with a number of contact points (4) arranged in the plane of the contact panel (2) of the device, which are connected to an electronic control and measuring device and which can be connected to the contact points of the printed conductors of the circuit boards (8) being tested, via rigid test probes (6) arranged in the longitudinal direction, whereby the contact points (4) in the printed circuit test device are supported against the applied contact pressure by electrically-conducting compression springs (28) which are located in holes (25) of a spring contact panel (26) of electrically-insulating material, and on which the rigid test probes (6) are directly supported, characterised in that the compression springs (28) are placed in the spring contact panel (26) with their centre section in direct contact with the walls of the holes (25), whereby in the longitudinal direction of the compression springs they have adjacent windings (33), the diameter of whose spring coils is a maximum in the end regions (30, 31) to provide stable control in the spring contact panel (26), and that at least one end (30, 31) the compression springs (28) take the form of an internal cone (34) to directly take a test probe (6) or one end of a contact pin (18) for connection to the test circuit of the printed circuit board test device, said cone resulting from a reduction and then an enlargement of the diameter of adjacent windings (33) of the spring coil.

2. Printed circuit board test device with a number of contact points (4) arranged in the plane of the contact panel (2) of the device, which are connected to an electronic control and measuring device and which can be connected to the contact points of the printed conductors of the circuit boards (8) being tested via rigid test probes (6) arranged in the longitudinal direction, whereby the contact points (4) in the printed circuit test device are supported against the applied contact pressure by electrically-conducting compression springs (28) which are located in holes (25) of a spring contact panel (26) of electrically-insulating material, and on which the rigid test probes (6) are directly supported, characterised in that the compression springs (28) are placed in the spring contact panel (26) with their centre section in direct contact with the walls of the holes (25), whereby in the longitudinal direction of the compression springs they have adjacent windings (33), the diameter of whose spring coils is a maximum in the end regions (30, 31) to provide stable control in the spring contact panel (26), and that at least one end (30, 31) the compression springs (28) have a pin-like or cone-like shape (36) for direct contact with an internal cone or other contact surface, said pin-like or cone-like shape resulting from a stepped and/or continuous reduction of the diameter of adjacent windings (33) of the spring coil.

3. Device according to one of the above claims, characterised in that the adjacent windings of the compression springs are interconnected mechanically, for instance by electrodeposition of a metal.

4. Device according to one of the above claims, characterised in that the end regions (30, 31) of the compression springs are coated with a special contact material to improve contact.

5. Device according to one of the above claims, characterised in that a driver board (12) used as a support for the electronic components (24) required for control, carries a studded contact panel connector (10) on its front end, which is located at the end of the spring contact panel (26) opposite the test probes, and in addition to making electrical contact with the compression springs (28), is also used to distribute force to the support sections (14, 16) in the printed circuit test device.

6. Device according to one of the above claims, characterised in that the spring contact panel (26) is made from ceramic or plastic.

7. Device according to one of the above claims, characterised in that the spring contact panel (26) is constructed from matrix-type segments which can be attached and joined together.

8. Device according to claim 7, characterised in that a solid section of contact panel, that can be withdrawn and replaced as a complete unit, is formed by inserting the contact pins (18) of one or more contact panel connectors (10) into the holes (25) or one or more segments of the spring contact panel (26).

9. Device according to claim 8, characterised in that the end of the compression spring opposite the test probe (6) has a spring contact tab (42) extending away from the spring in the longitudinal direction, for direct connection to contact areas of the driver board (12) supporting the electronic components of the contact panel section.

10. Device according to one of the above claims, characterised in that areas of differing contact density are provided in the plane of the contact panel (2), which can be interchanged in accordance with the requirements of the printed circuit boards (8) being tested.

**Revendications**

1. Dispositif de test électronique pour circuits imprimés présentant plusieurs points de contact (4), qui sont agencés dans le plan du champ de contact (2) du dispositif, qui sont connectés à un dispositif de commande et de mesure électronique et qui peuvent être connectés aux points de contact de pistes conductrices des circuits imprimés à tester (8) par l'intermédiaire de broches de test (6) rigides suivant la direction longitudinale, les points de contact (4) étant en appui dans le dispositif de test électronique pour circuits imprimés contre la pression de contact à appliquer de ressorts de pression électriquement conducteurs (28), qui sont agencés dans des trous (25) d'un organe de champ de contact à ressorts (26) en matière électriquement isolante et sur lesquels les broches de test rigides (6) sont directement en appui, caractérisé en ce que les ressorts de pression (28) sont guidés avec leur partie centrale directement en appui sur les parois des trous (25) dans l'organe de champ de contact a ressorts (26), ceux-ci présentant dans les zones d'extrémité (30, 31) suivant la direction longitudinale des ressorts de pression des spires situées l'une sur l'autre (33) de diamètre d'enroulement de ressort maximal pour la réalisation d'un guidage stable dans l'organe de champ de contact à ressorts (26), et en ce que les ressorts de pression (28) présentent à au moins une extrémité (30, 31), étant donné une diminution et ensuite une extension du diamètre d'enroulement de ressort en cas d'appui mutuel simultané des spires (33), la forme d'un cône interne (34) pour la réception directe d'une broche de test (6) ou d'une broche de contact (18) pour la connection au circuit de test du dispositif de test électronique pour circuits imprimes.

2. Dispositif de test électronique pour circuits imprimés présentant plusieurs points de contact (4), qui sont agencés dans le plan du champ de contact (2) du dispositif, qui sont connectés à un dispositif d'attaque et de mesure électronique et qui peuvent être connectés aux points de contact de pistes conductrices des circuits imprimés à tester (8) par l'intermédiaire de broches de test (6) rigides suivant la direction longitudinale, les points de contact (4) étant en appui dans le dispositif de test électronique pour circuits imprimés contre la pression de contact à appliquer de ressorts de pression électriquement conducteurs (28), qui sont agencés dans des trous (25) d'un organe de champ de contact à ressorts (26) en matière électriquement isolante et sur lesquels les broches de test rigides (6) sont directement en appui, caractérisé en ce que les ressorts de pression (28) sont guidés avec leur partie centrale directement en appui sur les parois des trous (25) dans l'organe de champ de contact à ressorts (26), ceux-ci présentant dans les zones d'extrémité (30, 31) suivant la direction longitudinale des ressorts de pression des spires situées l'une sur l'autre (33) de diamètre d'enroulement de ressort maximal pour la réalisation d'un guidage stable dans l'organe de champ de contact à ressorts (26), et en ce que les ressorts de pression (28) présentent à au moins une extrémité (30, 31), étant donné une diminution en gradin et/ou continue du diamètre d'enroulement de ressort en cas d'un appui mutuel simultané des spires (33), une forme de broche ou une forme semblable à un cône (36) pour le contact direct d'un cône interne ou d'une autre surface de contact.

3. Dispositif suivant l'une des revendications précédentes, caractérisé en ce que les spires situées l'une sur l'autre des ressorts de pression sont reliées l'une à l'autre mécaniquement par exemple par dépôt galvanique d'un métal.

4. Dispositif suivant l'une des revendications précédentes, caractérisé en ce que les zones d'extrémité (30, 31) des ressorts de pression sont recouvertes d'une matière de contact spéciale destinée à l'amélioration du contact.

5. Dispositif suivant l'une des revendications précédentes, caractérisé en ce qu'une plaque d'attaque (12) servant de support pour les composants électroniques (24) nécessaires à la commande porte à hauteur de sa face frontale un connecteur de champ de contact en forme de planche d'aiguilles (10), qui est agencé à hauteur de la face opposée aux broches de test de l'organe de champ de contact à ressorts (26) et qui sert tant au contact électrique direct avec les ressorts de pression (28) qu'à la déviation des forces vers les pièces de support (14, 16) dans le dispositif de test électronique pour circuits imprimés.

6. Dispositif de test électronique pour circuits imprimés suivant l'une des revendications précédentes, caractérisé en ce que l'organe de champ de contact à ressorts (26) est fabriqué en céramique ou en matière synthétique.

7. Dispositif de test électronique pour circuits imprimés suivant l'une des revendications précédentes, caractérisé en ce que l'organe de champ de contact à ressorts (26) est constitué de segments pouvant être mis en rangées à la manière d'une trame et pouvant être assemblés.

8. Dispositif suivant la revendication 7, caractérisé en ce que par l'introduction des broches de contact (18) d'un ou de plusieurs connecteurs de champ de contact (10) dans les trous (25) d'un ou de plusieurs segments de l'organe de champ de contact à ressorts (26) une section stable en soi du champ de contact est formée, laquelle peut être enlevée et interchangée comme unité complète.

9. Dispositif suivant la revendication 8, caractérisé en ce que l'extrémité opposée à la broche de test (6) du ressort de pression est pourvue d'une languette de contact élastique (42) s'étendant suivant la direction longitudinale du ressort à l'écart de celui-ci pour la prise directe sur des zones de contact de la plaque d'attaque (12) supportant les composants électroniques de la section du champ de contact.

10. Dispositif de test électronique pour circuits imprimés suivant l'une des revendications précédentes, caractérisé en ce qu'il y a des zones de densités de raccordement différentes dans le plan du champ de contact (2), qui sont mutuellement interchangeables suivant les besoins des circuits imprimés à tester (8).

FIG.1

FIG.2a

FIG.2b

FIG.3

FIG.4a          FIG.4b          FIG.4c